# EUROPEAN PATENT SPECIFICATION

(11) **EP 1 826 825 B1**
(45) Date of publication and mention of the grant of the patent: **31.12.2008**
(21) Application number: 05814585.5
(22) Date of filing: 02.11.2005
(51) Int. Cl.: H01L 31/042, H01L 31/0352, H01L 31/18

(54) **SOLAR CELL STRUCTURE COMPRISING REAR CONTACTS AND CURRENT COLLECTION BY MEANS OF TRANSISTOR EFFECT AND PRODUCTION METHOD THEREOF**
SOLARZELLENSTRUKTUR MIT RÜCKKONTAKTEN UND STROMSAMMLUNG MITTELS TRANSISTOREFFEKT UND HERSTELLUNGSVERFAHREN DAFÜR
STRUCTURE DE CELLULE SOLAIRE COMPRENANT DES CONTACTS POSTERIEURS ET DE COLLECTE DE COURANT PAR EFFET TRANSISTOR ET PROCEDE DE FABRICATION ASSOCIE

(30) Priority: 02.11.2004 ES 200402629
(43) Date of publication of application: 29.08.2007
(73) Proprietor: UNIVERSIDAD DEL PAIS VASCO-EUSKAL HERRIKO UNIBERSITATEA, 48940 Leioa (ES)
(72) Inventor: JIMENO CUESTA, Juan Carlos, E-48940 LEIOA (Vizcaya) (ES); URIARTE DEL RIO, Susana, E-48940 LEIOA (Vizcaya) (ES); IKARAN SALEGI, Carmen, E-48940 LEIOA (Vizcaya) (ES); HERNANDO BRIONGOS, Fernando, E-48940 LEIOA (Vizcaya) (ES); RODRIGUEZ CUESTA, Velia, E-48940 LEIOA (Vizcaya) (ES); MARTINEZ SANTOS, Victor, E-48940 LEIOA (Vizcaya) (ES); SAENZ NOVALES,Maria, Jose, E-48940 LEIOA (Vizcaya) (ES); GUTIERREZ SERRANO, Ruben, E-48940 LEIOA (Vizcaya) (ES); RECART BARAÑANO, Federico, E-48940 LEIOA (Vizcaya) (ES); BUENO MENDIETA, Gorka, E-48940 LEIOA (Vizcaya) (ES); LAGO AURRECOECHEA, Rosa, E-48940 LEIOA (Vizcaya) (ES); PEREZ MANZANO, Lourdes, E-48980 SANTURTZI (Bizkaia) (ES); FREIRE VELASCO, Iratxe, E-48007 BILBAO (Bizkaia) (ES)
(74) Representative: Carpintero Lopez, Francisco
(86) International application number: PCT/ES2005/000588
(87) International publication number: WO 2006/051132

(56) References cited:
- MARTIN A GREEN ET AL: "Very High Efficiency Silicon Solar Cells-Science and Technology" IEEE TRANSACTIONS ON ELECTRON DEVICES, IEEE SERVICE CENTER, PISACATAWAY, NJ, US, vol. 46, no. 10, October 1999 (1999-10), XP011017045 ISSN: 0018-9383
- MCINTOSH K R ET AL: "An experimental technique to measure the shunt resistance across a local region of a floating junction" SOLAR ENERGY MATERIALS AND SOLAR CELLS, ELSEVIER SCIENCE PUBLISHERS, AMSTERDAM, NL, vol. 64, no. 4, November 2000 (2000-11), pages 353-361, XP004217087 ISSN: 0927-0248
- HAVERKAMP H. ET AL.: 'Advancements in the development of back contact cell manufacturing processes' 19TH EUROPEAN SOLAR ENERGY CONFERENCE AND EXHIBITION, [Online] vol. 1, 07 June 2004 - 11 June 2004, PARIS, FRANCIA, XP008092610 Retrieved from the Internet: <URL:http://www.uni-konstanz.de/photovoltai cs.publication>
- VAN KERSCHAVER E., DE WOLF S., SZLUFCIK J.: 'Towards back contact silicon solar cells with screen printed metallisation' CONFERENCE RECORD OF THE TWENTY-EIGHTH IEEE PHOTOVOLTAIC SPECIALISTS CONFERENCE 2000, pages 209 - 212, XP008092607
- JOOSS W. ET AL.: 'Back contact buried contact solar cells with metallization wrap around electrodes' 28TH IEEE PHOTOVOLTAIC SPECIALISTS CONFERENCE 15 September 2000 - 22 September 2000, ANCHORAGE, USA, pages 176 - 179, XP008092606
- GEE J.M., SCHUBERT W., BASORE P.: 'Emitter wrap-through solar cell' PROCEEDINGS OF THE 23TH IEEE 1993, page 265, XP000437966
- NEU W. ET AL.: 'Low-cost multicrystalline back-contact silicon solar cells with screen printed multicrystalline back-contact silicon solar cells with screen printed metallization' SOLAR ENERGY MATERIALS AND SOLAR CELLS vol. 74, no. 1-4, October 2002, pages 139 - 146, XP004376936
- KRESS A. ET AL.: 'Investigations on low-cost back-contact silicon solar cells' SOLAR ENERGY MATERIALS AND SOLAR CELLS vol. 65, no. 1, 2001, pages 555 - 560, XP004217165

## Description

### OBJECT OF THE INVENTION

The object of the invention is a photoelectric solar cell as recited in claim 1 and in particular, a new solar cell structure which features all its electrical contacts on the rear side of the cell, yielding a greater photocurrent and in consequence, greater light-to-electricity conversion efficiency, due to the disappearance of the shadows caused by the metallization of the face side.

The structure of these cells facilitates their interconnection in order to form photoelectric modules, due to all their electrical contacts being located on the rear side of the cell.

Likewise, by means of the proposed solar cells, photoelectric modules with an improved appearance may be produced, as all their metallizations, electrical contacts and interconnections are located on the rear side of the cells, and therefore are hidden from the exterior of the module.

This new structure also allows the production of solar cells for applications under concentrated light, as they are not limited by the ohmic losses caused by the geometric limitations of the mesh of electrical contacts.

Lastly, the solar cells which are the object of this invention may be produced using low-quality materials, as the transistor effect favours the collection of current, its manufacture being compatible with low-cost industrial techniques.

The method of industrial manufacture of this invention, for the production of these solar cells, is also an object of this invention, as recited in claim 6.

### BACKGROUND OF THE INVENTION

Silicon solar cells with rear contacts have been developed in the past, first with the aim of obtaining a high efficiency, taking advantage of the absence of shadows on the face side of the cells, and later in order to simplify their interconnection, cheapening the manufacture of photoelectric modules, and at the same time achieving an improvement in their appearance; for this reason, their market has been directed mainly towards the photoelectric façade sector, which is most demanding regarding the appearance of projects.

In 1984, R. Swanson presented the Point Contact Solar Cell, PCSC. This cell, its manufacturing process having been improved, is currently manufactured and marketed by the SunPower company of Sunnyvale, CA,

USA. M.A. Green et al. IEEE Transactions on Electron Devices, vol. 46, n°10, 1999 discloses a silicon solar cell with the rear contacts.

The PCSC cell collects all the photogenerated current at the rear of the cell, that is, on the side where the electrical contacts are located, which presents the problem that the photons, which enter the cell through the face side, are absorbed a few microns from the surface and the conducting electrons, which hold the energy of said photons, must travel a noticeable distance until they are collected on the rear side of the cell, there to be converted into useful electric current, able to flow through an electric circuit outside the solar cell. Therefore, there is a high probability that these electrons, on their path towards the rear side of the cell, may yield their energy to one of the many mechanisms existing inside the semi-conductors, reducing the magnitude of the electric current generated.

The energy transfer mechanisms are associated with the purity and the quality of the semi-conductive material used; for this reason the PCSC cells are manufactured using silicon of the highest quality, grown by means of the Floating Zone (FZ) technique which, together with the special conditions of purity and cleanliness used in their manufacture, make the PCSC cell a highly efficient cell (over 20%) but which also entails a high cost.

For this reason, PCSC cells are currently directed towards highly specific markets, such as the manufacture of photoelectric aeroplanes, or high-efficiency photoelectric systems which operate under concentrated light.

In 1993, J. Gee, from the SANDIA laboratories in NM, USA, presented the Emitter Wrap Through (EWT) cell. In this structure, all the electrical contacts, as in the case of the PCSC cell, are located on the rear side of the cell. However, in this cell, the majority of the current is collected at the face side, near to the area where the photons are absorbed, which makes possible a high conversion efficiency even using lower quality substrates.

In order to extract the current through the electrical contacts on the rear side, it is necessary to build an electric path which connects the face and rear sides, drilling a series of holes, by means of laser, which connect the n-type region (doped with phosphorous) of the face side with the n-type regions of the rear side, on which the electrical contacts of the negative pole of the solar cell are located.

In order to carry out the electrical connection between the face and rear sides, the holes are diffused with phosphorous in order to create an n-type continuous path between both sides. The substrate, or the material on which the cell structure is built, is p-type, the opposite of that of the electrical connections made between the sides; this makes it necessary for the main pn interface, where the collection of current is at its greatest, to be located on the face side of the cell.

The EWT cell requires the use of a laser for the drilling of multiple holes and besides, subsequent to this drilling process it is necessary to proceed with other processes for the chemical elimination of damaged areas and the diffusion of the holes. It is frequently necessary to resort to photolithography for the definition of the complex geometry of the rear side. Thus, there must be n-type regions beneath the diffused holes of the same type, likewise p-type regions contacting the bulk of the substrate or base of the solar cell.

For these reasons, the EWT cell is highly suitable for the manufacture of rear-contact cells, but its manufacture is complex and the execution of the necessary number of holes increases the cost of its execution.

Other types of structure intended for the simplification of the manufacture of rear-contact cells are known, with current collection at their face side, as in the case of the EWT cell, but which require a lower number of holes for the passage of the current, such as the so-called Metallization Wrap Around (MWA) and the Metallization Wrap Through (MWT) cells, which incorporate a fine metallization mesh on their face side.

In these structures, the current is collected at the face side and directed towards the metallic mesh, as occurs in the case of conventional cells, but the current collecting lines, to which the inter-cell connecting strips will be soldered, are located only on the rear side of the cell. The current is passed from the face surface to the rear surface by means of a metallic ring located around the circumference of the cell, in the case of the MWA cell, or by means of holes which will contact the metallic mesh on the face with the collector lines at the rear, in the case of the MWT cells. In this last case, the holes are usually metallized, which complicates the process of manufacture. In the MWT structure, the current is guided throughout the face surface by means of the lines of the metallic mesh; for this reason the ohmic losses may be extremely low. Besides, the fact that the current transfer holes are metallized likewise contributes to the reduction of these losses, which allows the use of a low number of holes.

### DESCRIPTION OF THE INVENTION

This invention relates to a structure for a low-cost, rear-contact solar cell.

The structure proposed, as in the EWT, MWT and MWA structures, collects the photogenerated current on its face side, using multiple bipolar transistors for its transport to the rear side; said transistors, in the event of using p-type substrates, will be npn-type.

In order that the transport of current may be carried out in an effective manner, the thickness of the base region is significantly reduced, in such a way that the bipolar transistors feature a high current gain.

With the use of the multicrystalline silicon substrates currently available, with a thickness of 50 micrometres, current collections of over 95% may be achieved.

The bipolar transistors integrated in the structure of the solar cell which is the object of this invention have the same function as the holes made in the EWT-structured cells, but with the peculiarity that they may extend over a greater surface of the wafer, reducing the ohmic losses caused in the EWT and MWT cells, as in these structures, the total area of the holes causes a reduction in the optically active surface area of the cell and, therefore, losses in the photocurrent generated.

In the case of the structure which is the object of this invention, there is no reduction in the active surface area of the solar cell and, therefore, it is possible to extend the transistor area to practically the entirety of the solar cell.

In the new structure proposed, which hereinafter we shall call Transistor Wrap Through (TWT), the bipolar transistors, of a very small thickness, are adjacent to portions of the solar cell of a much greater thickness. These zones or regions of greater thickness, which we shall call thick, in comparison with the areas occupied by transistors, provide the solar cell with the mechanical rigidity which is necessary for its manufacture in industrial environments.

The electrical contacts, all of which are located on the rear side of the cell, are made on the thick regions, but in the case of p-type substrates and npn transistors, those corresponding to the negative terminal may be carried out on the transistors themselves, in a simpler manufacturing process.

### DESCRIPTION OF THE DRAWINGS

- Figure 1: portrays schematically the working principle of the structure of the TWT cell, which is the object of this invention.
- Figure 2: portrays the structure of a solar cell in accordance with the object of this invention, in which the electrical contacts of the positive pole are located on the thick zones of the cell, while the contacts of the negative pole are arranged at the thinner regions of the base of the substrate.
- Figure 3: portrays the structure of a solar cell in accordance with the object of this invention, in which the electrical contact of both the positive pole and that of the negative pole are arranged on the thick zones of the cell.
- Figure 4: portrays schematically the manufacturing process of a TWT cellular structure, in accordance with the embodiment portrayed in Figure 1.
- Figure 5: portrays schematically the manufacturing process of a TWT cellular structure, in accordance with the embodiment portrayed in Figure 2.

### PREFERRED EMBODIMENT OF THE INVENTION

This invention relates to a new solar cell structure in which both metallic contacts, which form the positive and negative electrodes of the device, are located on the rear side of the cell, the face side being understood to be the side opposite to the rear side, and to be the side of the device which is placed facing the solar radiation for absorption of the same and its subsequent conversion into electricity.

The TWT structure proposed by the invention is comprised of a base or substrate which may consist of silicon, either p-type or n-type. The base of the cell shall be limited on both sides by emitters, or highly doped regions of a type which is opposite to that of the base; that is to say, n-type emitters for p-type bases or p-type emitters for n-type bases.

In selected regions of the rear side, emitters of the same type as the base shall be made; for example, p-type emitters for p-type bases, in order to facilitate the electrical contact of the same.

The region of the base shall feature thinnings, performed by a thinning process, which will bring the emitters of both sides closer together, creating an effective npn-type bipolar transistor for p-type bases and pnp-type for n-type bases. This transistor will carry out an effective transport, towards the emitter of the rear side, of the majority-carrier current collected by the emitter on the face side. The collection of the majority-carriers by the face-side emitter, which will be the base minority carriers, guarantees a high collection of photocurrent. The construction of highly effective transistors, based at very thin base regions, guarantees good conduction of the current towards the metallic contacts and the external electrical circuit.

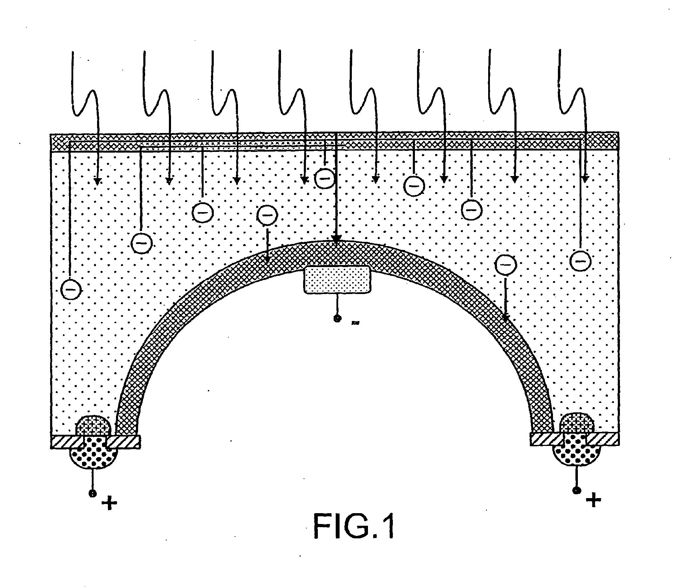

Figure 1 portrays the operating principle of the TWT cell which is the object of this invention. The light enters the device via its face side and will be absorbed in the proximity of the same. The face side of the cell features a pn joint, able to collect the photogenerated current, whose fundamental part corresponds to the electron flow, in the case of p-type bases, generated in the base of the cell. This current will flow over the surface via its n-type emitter until it reaches a thinning in the base, at which the associated bipolar transistor will transport it to the n-type emitter located on the rear side of the cell and from there, the flow of electrons will travel superficially over the n-type emitter on the rear side until it reaches a metallic contact, through which it will be supplied to the external circuit.

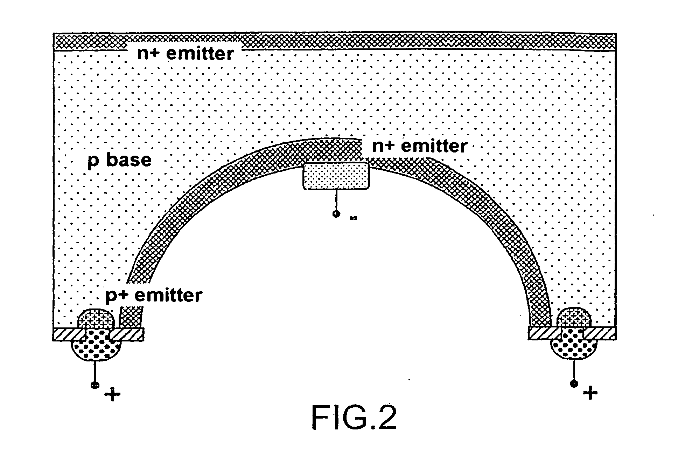

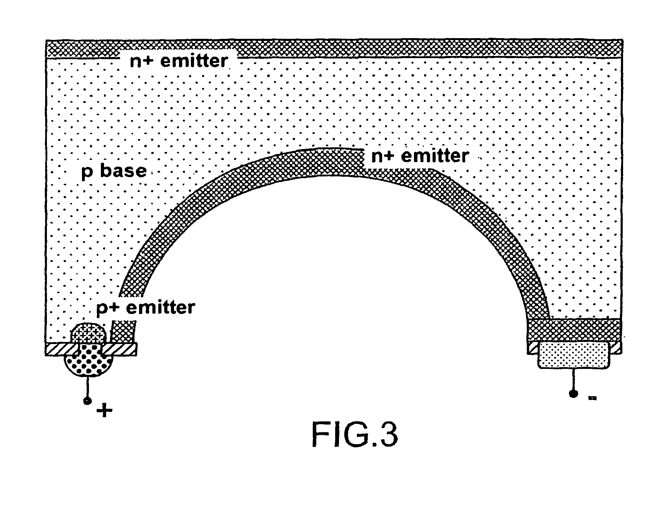

Figures 2 and 3 portray two possible embodiments of the TWT structure which is the object of this invention. In both embodiments, it may be seen that all the electrical contacts, both positive and negative, are located on the rear side of the cell, which coincides with the lower part of the cell. Between the two sides, face and rear, thinnings are carried out, represented at the central part of the figures, and produced by the thinning of the rear side, although they could also be located in different zones, or be produced by the thinning of the face side of the cell.

The thinnings generate npn transistors, for the structures portrayed in the figures, that is to say, with p-type substrates, and would generate pnp transistors in the case of n-type bases flanked by p-type emissions, located on each side of the wafer.

The structure of the cell in Figure 2 uses the thinned regions of the base for the placement in the same of the electrical contacts of the negative pole of the solar cell, while the electrodes which form the positive pole are located on the thick zones of the cell.

The cell in Figure 3 presents the two electrical contacts, positive and negative, on thick areas of the cell. In this case, the electric current caused by the electrons must travel through a greater portion of the rear n-type emitter; for this reason, its contribution to the ohmic losses will be greater than that of the cell in Figure 2.

On the other hand, the disposal of both contacts on thick regions will facilitate the industrial manufacturing of these contacts and their subsequent sheathing with copper strips, this being necessary for the inter-cell connections.

The manufacture of both structures may be carried out by means of techniques which are considered to be industrial, basically due to their capacity of being put into effect on large batches of cells.

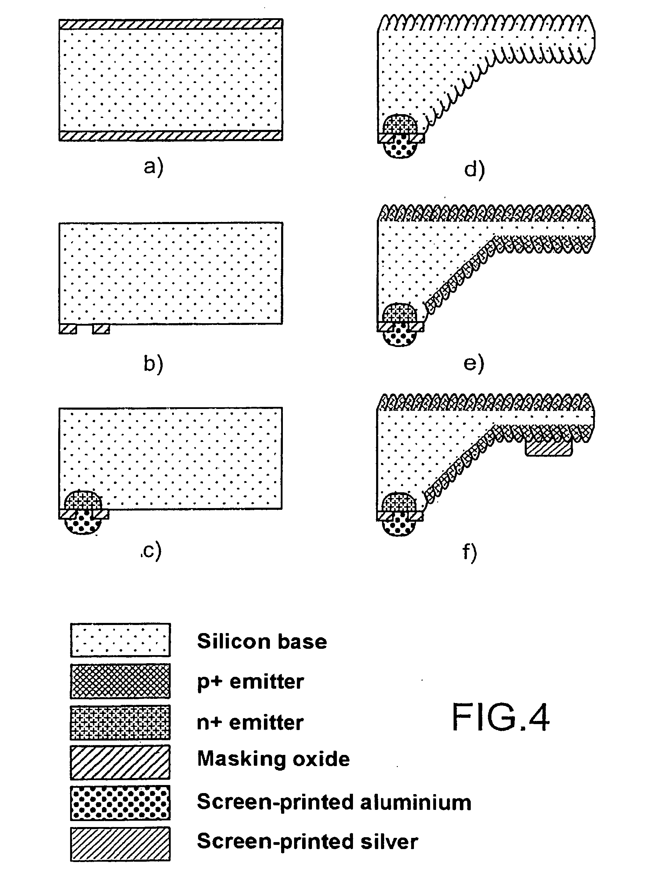

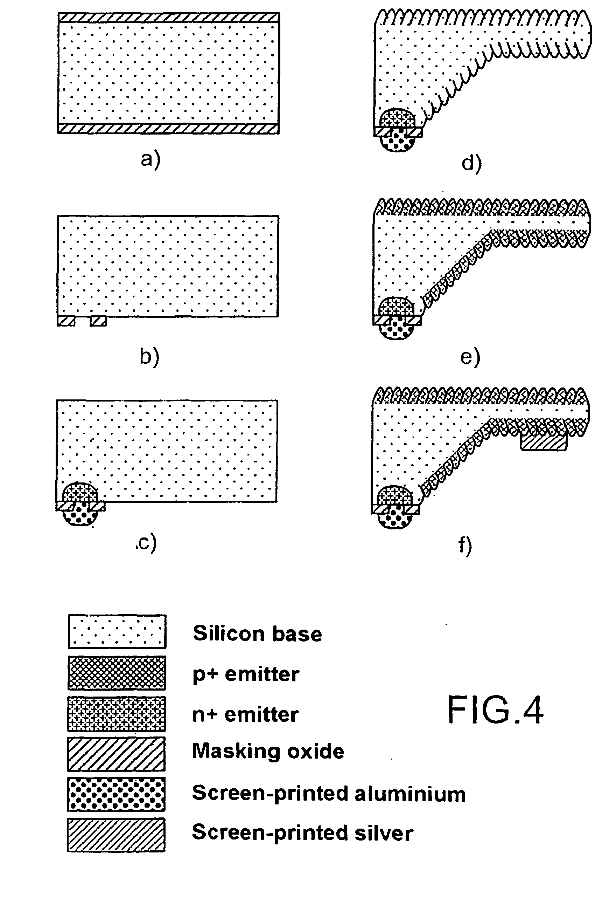

Some examples of manufacture, portrayed in Figures 4 and 5, and which permit the production of cell structures such as those portrayed in Figures 2 and 3, are included below.

### Example 1:

For the manufacture of the cell in Figure 1, the manufacturing process to be followed might be that which is detailed below:
a) The starting wafer, p-type in this case, is cleaned and thinned in a chemical bath until all traces of cracks and microcracks which may have been caused or induced during preceding processes, such as the sawing from the ingot, have disappeared. The wafer is oxidised at a high temperature in an oven and in an atmosphere of oxygen, or steam, or a combination of both, be it by means of bubbling gas through water in a flask, or by the recombination of oxygen and hydrogen. In this way, a structure such as that portrayed in Figure 4.a. will be produced.
b) By means of a photolithographic or screen printing process, small portions of the rear side of the cell are masked; these will form the thick portions of the cell, with windows for the introduction of the p-type diffusion. The silicon oxide which is not covered by the mask is eliminated, thus producing a structure of the type portrayed in Figure 4.b.
c) A layer of aluminium is selectively deposited. Due to the fact that the most critical dimensions of this structure, the width of the lines of oxide and the size of the windows, may be greater than 200 micrometres, precisions of alignment higher than +/-100 micrometres will not be required; it being possible to use screen printing for the depositing of these layers of aluminium. A high-temperature process, in the region of 800 to 1100°C will bring about a diffusion of the aluminium towards the interior of the silicon, creating the p+ regions. On completion of this process, the structure portrayed in Figure 4.c. will have been produced.
d) By means of a chemical attack, the base of the cell will be thinned at the regions which are not protected by the silicon oxide, completing this step with an anisotropic attack, creating the structure portrayed in Figure 4.d.
e) A diffusion of phosphorous in an atmosphere of phosphorus oxychloride vapour, for example, will create n-type emitters on all the surfaces which are not covered by the oxide or by the aluminium, which gives rise to the face and rear emitters which will be the source of the npn transistors at the thin regions of the base. The structure of the cell will be as portrayed in Figure 4.e.
f) The depositing of passivating layers on the surfaces and of anti-reflective layers on the face side of the cell will increase the efficiency of the same. Finally, a screen-printed layer of silver will create the negative contact of the cell. This screen printing, at the same time, may be extended to the aluminium deposits which cover the p-type emitters. The silver located on these will facilitate their soldering and therefore the connection of the copper strips used for the inter-cell connections. The structure portrayed in Figure 4.f. will have been achieved, the solar cell now having been completed.

### Example 2:

For the manufacture of the cell in Figure 2, the manufacturing process to be followed might be that which is detailed below:
a) The starting wafer, p-type in this case, is cleaned and thinned in a chemical bath until all traces of cracks and microcracks which may have been caused or induced during preceding processes, such as the sawing from the ingot, have disappeared. The wafer is diffused with phosphorous in a high-temperature oven, in the range of 800 to 1100°C and in an atmosphere of phosphorus oxychloride. The wafer is oxidised in a high-temperature oven and in an atmosphere of oxygen, or steam, or a combination of both, be it by means of bubbling gas through water in a flask, or by the recombination of oxygen and hydrogen. In this way, a structure such as that portrayed in Figure 5.a. will be produced.
b) By means of a photolithographic or screen printing process, small portions of the rear side of the cell are masked; these will form the thick portions of the cell, with windows for the introduction of the p-type diffusion. The silicon oxide which is not covered by the mask is eliminated, thus producing a structure of the type portrayed in Figure 5.b.
c) A layer of aluminium is selectively deposited. Due to the fact that the most critical dimensions of this structure, the width of the lines of oxide and the size of the windows, may be greater than 200 micrometres, precisions of alignment higher than +/-100 micrometres will not be required; it being possible to use screen printing for the depositing of these layers of aluminium. A high-temperature process, in the region of 800 to 1100°C will bring about a diffusion of the aluminium towards the interior of the silicon, creating the p+ regions. On completion of this process, the structure portrayed in Figure 5.c. will have been produced.
d) By means of a chemical attack, the base of the cell will be thinned at the regions which are not protected by the silicon oxide, completing this step with an anisotropic attack, creating the structure portrayed in Figure 5.d.
e) A diffusion of phosphorous in an atmosphere of phosphorus oxychloride vapour, for example, will create n-type emitters on all the surfaces which are not covered by the oxide or the aluminium, which gives rise to the face and rear emitters which will be the source of the npn transistors at the thin regions of the base. The structure of the cell will be as portrayed in Figure 5.e.
f) The depositing of passivating layers on the surfaces and of anti-reflective layers on the face side of the cell will increase the efficiency of the same. Finally, a screen-printed layer of silver will create the negative contact of the cell. This screen printing, at the same time, may be extended to the aluminium deposits which cover the p-type emitters. The silver located on these will facilitate their soldering and therefore the connection of the copper strips used for the inter-cell connections. The structure portrayed in Figure 5.f. will have been achieved, the solar cell now having been completed.;

## Claims

1. A solar cell structure, comprised of a base substrate, a front side on which the light falls, and a rear side on which all the electrical contacts are arranged and which collects the carriers which are photogenerated on its front side, **characterised in that** the base substrate features thinned zones, or zones of a reduced thickness, in which are to be found bipolar transistors which transport the carriers photogenerated on the front side towards the rear side, these being npn bipolar transistors for p-type base substrates, and pnp bipolar transistors for n-type base substrates.

2. A solar cell structure, according to claim 1, **characterised in that** it incorporates many bipolar transistors, spread over practically the entirety of the solar cell, leaving a few thick zones, that is to say, without thinning, which provide the cell with the mechanical rigidity which is necessary for its manufacture by industrial methods.

3. A solar cell structure, according to claim 1, **characterised in that** the base substrate is multi-crystalline silicon, and **in that** the thinned regions present a thickness of not less than 50 micrometres.

4. A solar cell structure, according to claim 1, **characterised in that** the electrical contacts which correspond to the emitter or to the collector of the bipolar transistor, that is to say, the negative terminal for npn transistors and the positive terminal for pnp transistors, are located on the thinned region of the solar cell.

5. A solar cell structure, according to claim 1, **characterised in that** both the electrical contacts which correspond to the positive pole and those of the negative pole are located on the thick regions of the solar cell, thus facilitating the electrical interconnection of solar cells.

6. A method of manufacturing a solar cell structure comprising the step of providing a base substrate having a front side for receiving the light and a rear side on which electrical contacts are arranged and which collects the carriers which are photogenerated on said front side, **characterised in that** the method further comprises the steps of forming at least one thinned zone or zone of reduced thickness in said base substrate, and forming bipolar transistors in said thinned zone of the base substrate, said bipolar transistors configured for transporting the carriers photogenerated on the front side towards the rear side, these bipolar transistors being npn transistors for p-type base substrates, and pnp bipolar transistors for n-type base substrates.

7. A process of manufacture of a solar cell structure with rear contacts according to claim 6, **characterised in that** when p-type silicon substrates are used, it includes the following stages:
a) An oxidation of the substrate surfaces,
b) A selective elimination of the oxide by means of masking by photolithography or by screen printing and a subsequent chemical elimination of the oxide not covered by the mask,
c) The depositing of a film of aluminium, by evaporation or by screen printing, which shall be aligned with the windows made in the oxide, and a subsequent diffusion of the aluminium deposited, creating an aluminium-rich region of silicon,
d) A chemical attack, and subsequent texturing, of the surfaces which are not covered by the oxide or by the aluminium,
e) A phosphorous diffusion of all the surfaces which are not covered by the silicon oxide or by the aluminium, and
f) The depositing of metal for the positive and negative electrical contacts, it being possible to use silver, deposited by means of screen-printing.

8. A process of manufacture of a solar cell structure with rear contacts, according to claim 7, **characterised in that** prior to the oxidation of the surfaces of the substrate (a), a phosphorous diffusion of the aforementioned surfaces of the substrate is produced.

## Patentansprüche

1. Solarzellenaufbau, enthaltend ein Basissubstrat, eine Vorderseite, auf die Licht fällt, und eine Rückseite, auf der alle elektrischen Kontakte angeordnet sind und die die auf ihrer Vorderseite durch Licht erzeugten Träger sammelt, **dadurch gekennzeichnet, dass** das Basissubstrat verdünnte Zonen oder Zonen mit verminderter Decke aufweist, in welchen Bipolartransistoren zu finden sind, die die auf der Vorderseite durch Licht erzeugten Träger zur Rückseite transportieren, wobei diese npn-Bipolartransistoren für p-Typ-Basissubstrate und pnp-Bipolartransistoren für n-Typ-Basissubstrate sind.

2. Solarzellenaufbau nach Anspruch 1, **dadurch gekennzeichnet, dass** er viele Bipolartransistoren enthält, die praktisch über die Gesamtheit der Solarzelle verteilt sind, wobei einige dicke Zonen belassen sind, das heißt ohne Verdünnungen, die der Zelle die mechanische Steifigkeit verleihen, die für ihre Herstellung mit industriellen Verfahren erforderlich ist.

3. Solarzellenaufbau nach Anspruch 1, **dadurch gekennzeichnet, dass** das Basissubstrat multikristallines Silizium ist und dass die verdünnten Regionen eine Dicke von nicht weniger als 50 Mikrometern aufweisen.

4. Solarzellenaufbau nach Anspruch 1, **dadurch gekennzeichnet, dass** die elektrischen Kontakte, die dem Emitter oder dem Kollektor des Bipolartransistors entsprechen, das heißt dem negativen Anschluss für npn-Transistoren und dem positiven Anschluss für pnp-Transistoren, auf der verdünnten Region der Solarzelle angeordnet sind.

5. Solarzellenaufbau nach Anspruch 1, **dadurch gekennzeichnet, dass** sowohl die elektrischen Kontakte, die dem positiven Pol entsprechen, als auch diejenigen des negativen Pols in den dicken Regionen der Solarzelle angeordnet sind, so dass sie die elektrische Verbindung zwischen Solarzellen erleichtern.

6. Verfahren zur Herstellung eines Solarzellenaufbaus, enthaltend den Schritt des Vorsehens eines Basissubstrats, das eine Vorderseite zur Aufnahme von Licht und eine Rückseite hat, an welcher elektrische Kontakte angeordnet sind und welche die Träger sammelt, die auf der Vorderseite durch Licht erzeugt werden, **dadurch gekennzeichnet, dass** das Verfahren ferner die Schritte des Bildens mindestens einer verdünnten Zone oder Zone mit verminderter Dicke in dem Basissubstrat und des Bildens von Bipolartransistoren in der verdünnten Zone des Basissubstrats enthält, welche Bipolartransistoren dafür konfiguriert sind, die auf der Vorderseite durch Licht erzeugten Träger zur Rückseite zu transportieren, wobei diese Bipolartransistoren npn-Transistoren für p-Typ-Basissubstrate und pnp-Transistoren für n-Typ-Basissubstrate sind.

7. Verfahren zur Herstellung eines Solarzellenaufbaus mit Rückseitenkontakten nach Anspruch 6, **dadurch gekennzeichnet, dass** es dann, wenn p-Typ-Siliziumsubstrate verwendet werden, die folgenden Stufen enthält:
a) Eine Oxidation der Substratsoberflächen,
b) Eine selektive Beseitigung des Oxids mittels Maskierung durch Fotolithographie oder durch Siebdruck und eine anschließende chemische Beseitigung des nicht von der Maske bedeckten Oxids,
c) Das Aufbringen eines Aluminiumfilms durch Verdampfen oder durch Siebdruck, der zu den in dem Oxid hergestellten Fenstern ausgerichtet sein soll, und eine anschließende Diffusion des abgeschiedenen Aluminiums, wodurch eine mit Aluminium angereicherte Siliziumregion geschaffen wird,
d) Einen chemischen Angriff und anschließendes Texturieren der Oberflächen, die nicht mit dem Oxid oder dem Aluminium bedeckt sind,
e) Eine Phosphordiffusion aller Oberflächen, die nicht mit dem Siliziumoxid oder dem Aluminium bedeckt sind, und
f) Das Aufbringen von Metall für die positiven und negativen elektrischen Kontakte, wobei die Verwendung von Silber möglich ist, das mittels Siebdruck aufgebracht wird.

8. Verfahren zur Herstellung eines Solarzellenaufbaus mit Rückseitenkontakten nach Anspruch 7, **dadurch gekennzeichnet, dass** vor der Oxidation der Substratsoberflächen (a) eine Phosphordiffusion der vorstehend genannten Oberflächen des Substrats bewirkt wird.

## Revendications

1. Structure de cellule solaire comprenant un substrat de base, une face frontale sur laquelle arrive la lumière et une face arrière sur laquelle sont arrangés tous les contacts électriques et qui collecte les porteurs qui sont photogénérés sur sa face frontale,
**caractérisée en ce que**
la base du substrat comporte des zones amincies ou des zones d'épaisseur réduite dans lesquelles on trouve des transistors bipolaires qui transportent les porteurs photogénérés sur la face frontale à travers la face arrière, ces transistors étant des transistors bipolaires npn pour des bases de substrat de type p et des transistors bipolaires pnp pour des bases de substrat de type n.

2. Structure de cellule solaire selon la revendication 1,
**caractérisée en ce qu'**
elle incorpore beaucoup de transistors bipolaires s'étendant sur pratiquement toute la cellule solaire laissant quelques zones épaisses c'est-à-dire sans amincissement qui fournissent à la cellule la rigidité mécanique nécessaire pour sa fabrication par des méthodes industrielles.

3. Structure de cellule solaire selon la revendication 1,
**caractérisée en ce que**
le substrat de base est du silicone multicristallin et les régions amincies présentent une épaisseur qui n'est pas inférieure à 50 micromètres.

4. Structure de cellule solaire selon la revendication 1,
**caractérisée en ce que**
les contacts électriques qui correspondent à l'émetteur ou au collecteur du transistor bipolaire c'est-à-dire la borne négative pour les transistors npn et la borne positive pour les transistor pnp sont localisés sur les régions amincies de la cellule solaire.

5. Structure de cellule solaire selon la revendication 1,
**caractérisée en ce que**
les deux contacts électriques qui correspondent au pôle positif et ceux du pôle négatif sont localisés dans la région épaisse de la cellule solaire ce qui facilite la connexion électrique des cellules solaires.

6. Procédé de fabrication d'une structure de cellule solaire comprenant les étapes consistant à :
- prendre un substrat de base ayant une face frontale pour recevoir la lumière et une face arrière sur laquelle sont disposés les contacts électriques et qui collectent les porteurs photogénérés sur la face frontale,
**caractérisée en ce que**
la procédé comprend également les étapes de formation d'au moins une zone amincie ou une zone d'épaisseur réduite dans le substrat de base et consistant à former des transistors bipolaires sur la zone amincie du substrat de base, ces transistors bipolaires étant configurés pour transporter les porteurs photogénérés de la face frontale vers la face arrière, ces transistors bipolaires étant des transistors npn pour des substrats de base de type p et des transistors bipolaires pnp pour des transistors de base de type n.

7. Procédé de fabrication de structure de cellule solaire avec des contacts arrière selon la revendication 6,
**caractérisé en ce que**
lorsqu'on utilise des substrats en silicone de type p, il comporte les étapes suivantes :
a) oxydation des surfaces de substrat,
b) élimination sélective des oxydes à l'aide de masque selon le principe de la photolithographie ou en sérigraphie suivie d'une élimination chimique des oxydes non recouverts par le masque,
c) dépose d'un film d'aluminium, par évaporation ou par sérigraphie aligné avec les fenêtres faites dans l'oxyde suivie d'une diffusion de l'aluminium déposé créant des régions de silicone riche en aluminium,
d) attaque chimique suivie d'une texture ultérieure des surfaces qui ne sont pas recouvertes par l'oxyde ou par l'aluminium,
e) diffusion de phosphore sur toutes les surfaces qui ne sont pas couvertes par l'oxyde de silicion ou par l'aluminium, et
f) dépose de métal pour les contacts électriques positifs et négatifs, avec possibilité d'utiliser de l'argent déposé par sérigraphie.

8. Procédé de fabrication d'une cellule de structure solaire avec des contacts arrière selon la revendication 7,
**caractérisé en ce qu'**
avant l'oxydation des surfaces du substrat (a), on produit une diffusion de phosphore sur les surfaces du substrat mentionnées précédemment.
